# EUROPÄISCHE PATENTANMELDUNG

(11) **EP 2 650 930 A1**
(43) Veröffentlichungstag der Anmeldung: **16.10.2013**
(21) Anmeldenummer: 12002602.6
(22) Anmeldetag: 12.04.2012
(51) Int. Cl.: H01L 31/18, H01L 31/0687, C30B 33/06, H01L 21/18

(54) **Solarzellenstapel**

(71) Anmelder: AZURSPACE Solar Power GmbH, 74072 Heilbronn (DE)
(72) Erfinder: Guter, Wolfgang, Dr., 70190 Stuttgart (DE)
(74) Vertreter: Koch Müller Patentanwaltsgesellschaft mbH

(57) **Zusammenfassung**

Solarzellenstapel aufweisend mehrere Halbleiter-Solarzellen aus Ge und / oder einer Ge-Verbindung und einer III-V Verbindung, wobei jede Halbleiter-Solarzelle einen P/N Übergang beinhaltet, und der Solarzellenstapel einen ersten Solarzellenteil, mit einer Oberseite und einer Unterseite und einer ersten Halbleiter-Solarzelle und wobei die erste Halbleiter-Solarzelle eine erste Gitterkonstante aufweist, und der Solarzellenstapel einen zweiten Solarzellenteil mit einer Oberseite und einer Unterseite und einer zweiten Halbleiter-Solarzelle und wobei die zweite Halbleiter-Solarzelle eine zweite Gitterkonstante aufweist und wobei der erste Solarzellenteil mit der Unterseite auf der Oberseite des zweiten Solarzellenteils kraftschlüssig aufeinander angeordnet ist und wobei zwischen der Unterseite des ersten Solarzellenteils und der Oberseite des zweiten Solarzellenteils ein abrupter Unterschied zwischen der ersten Gitterkonstante und der zweiten Gitterkonstante ausgebildet ist und der Unterschied zwischen der ersten Gitterkonstante und der zweiten Gitterkonstanten mindestens 0.5% beträgt oder eine amorphe Schicht ausgebildet ist, und wobei der erste Solarzellenteil und / oder der zweite Solarzellenteil zusätzlich zu der ersten Halbleiter-Solarzelle oder der zweiten Halbleiter-Solarzelle eine weitere Halbleiter-Solarzelle umfasst und wobei der erste Solarzellenteil und / oder der zweite Solarzellenteil eine metamorphe Zwischenschicht umfasst, und wobei die metamorphe Zwischenschicht eine erste Schichtdicke umfasst und die metamorphe Zwischenschicht entlang der Dickenerstreckung der Zwischenschicht die Gitterkonstante um mindestens 0.5% verändert.

## Beschreibung

Die Erfindung betrifft ein Solarzellenstapel gemäß dem Oberbegriff des Patentanspruchs 1.

Aus der US 2006 / 0021565 A1 ist ein Solarzellstapel mit mehreren Solarzellen bekannt. Hierbei wird in einer ersten Ausführungsform auf ein aktives Si-Substrat eine dünne hetero Halbleitersaatschicht aufgebracht und anschließend auf die Saatschicht die weiteren III-V Solarzellen epitaxiert. In einer anderen Ausführungsform wird als erster Solarzellenteil eine bereits gewachsene III-V Mehrfachsolarzellenstruktur, bestehend aus einem Stapel von mehreren III - V Halbleiter-Solarzellen, auf eine Siliziumsolarzelle mit einer n+ dotierten Oberfläche gebonded, d.h zusammengefügt, um eine kovalente niederohmige Verbindung auszubilden. Hierbei weist der erste Solarzellenteil an der zu bondenden Oberfläche eine Tunneldiode mit zwei unterschiedlich dotierten Schichten aus GaAs auf. Sowohl die Siliziumoberfläche als auch die Oberfläche des III-V-Solarzellenteils sind äußerst plan ausgeführt. Eine Schwierigkeit bei dem Zusammenfügen besteht in einer großen Durchbiegung der gebondeten Scheiben in Folge der unterschiedlichen Kristallgitter und der unterschiedlichen thermischen Ausdehnungskoeffizienten. Es wird versucht mittels spezieller Rückseitenbeschichtung die Durchbiegung des Solarzellenstapels zu verringern.

Von Wolfgang Guter et al, Current-matched triple junction solar cell reaching 41,1% conversion efficiency under concentrated sunlight, in: Applied Physics Letters 94, 223504 (2009), ist eine III-V Mehrfachsolarzelle mit einer metamorphen Zwischenschicht bekannt.

Derartige metamorphe Zwischenschichten vermitteln zwischen den unterschiedlichen Gitterkonstanten von aufeinanderliegenden Halbleiter-Solarzellen. Die unterschiedlichen Gitterkonstanten der Halbleiterschichten ergeben sich aus der Auswahl der Halbleitermaterialien nach verschiedenen Bandlücken, um den Wirkungsgrad des Solarzellenstapels zu erhöhen, wobei die metamorphen Zwischenschichten ein kristallines Wachstum einer zweiten

Halbleiter-Solarzelle auf einer ersten Halbleiter-Solarzelle mit einer veränderten Gitterkonstante ermöglicht. Ein Nachteil der metamorphen Zwischenschichten ist, dass die Oberfläche der zweiten Halbleiter-Solarzelle zwar kristallin ausgebildet ist, jedoch aufgrund von Fehlpassungsversetzungen und anderen Kristalldefekten eine Vielzahl von tafelbergartigen Erhöhungen und allgemein eine erhöhte Rauheit aufweist und hierdurch die Oberfläche der zweiten Halbleitersolarzellen für ein Waferbonden nicht geeignet erscheint. Außerdem sind die Solarzellen nach der Epitaxie aufgrund der Verspannung der gitterfehlangepassen Schichten stärker verbogen, was Waferbonden ebenfalls ausschließt. Deshalb werden zur Ausbildung von Mehrfachsolarzellen, wie insbesondere eine Tripelzelle, ausschließlich epitaktische Prozessschritte angewendet. Hierdruch lässt sich ein aufwändiger halbleitertechnologischer Bondingprozess vermeiden.

Des Weiteren sind J. Boisvert et al, Development of advanced space solar cells at spectrolab, in: Photovoltaic Specialists Conference (PVSC), 2010 35th IEEE, 20-25 June 2010, Honolulu, ISSN: 0160-8371, weitere III-V Mehrfachsolarzellenstapel bekannt. In einer Ausführungsform werden Solarzellenstapel aus mehr als drei einzelnen Halbleiter-Solarzellen durch ein Halbleiterbonden (SBT) eines ersten Solarzellenteils mit einem zweiten Solarzellenteil hergestellt. Um eine ausreichende planare Oberfläche, geringer Oberflächenrauheit und geringe Verbiegung für das Zusammenbonden zu erhalten, werden der erste Solarzellenteil und der zweite Solarzellenteil gitterangepasst, d. h. ohne metamorphe Zwischenschichten, auf den jeweiligen Substarten epitaxiert. Hierbei wird eines der Solarzellenteile auf dem sehr kostenintensiven InP Substrat gewachsen. Derartig teure Substrate werden in der Produktion meist entweder vor dem Zusammenfügen oder nach dem Zusammenfügen abgelöst und wiederverwendet.

Aus J. Simon et al, Metamorphic GaAsP buffers for Growth of wide-bandgap InGaP solar cells, in: Journal OF APPLIED PHYSICS 109, 013708 -1 bis 013708-5, (2011), sind weitere Herstellverfahren und Ausführungsformen für einen III-V dreifach Solarzellenstapel bekannt.

Vor diesem Hintergrund besteht die Aufgabe der Erfindung darin, eine Vorrichtung anzugeben, die den Stand der Technik weiterbildet.

Die Aufgabe wird durch einen Solarzellenstapel mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Solarzellenstapel aufweisend mehrere Halbleiter-Solarzellen aus Ge und / oder einer Ge-Verbindung und einer III-V Verbindung, wobei jede Halbleiter-Solarzelle einen P/N Übergang beinhaltet, und der Solarzellenstapel einen ersten Solarzellenteil, mit einer Oberseite und einer Unterseite und einer ersten Halbleiter-Solarzelle und wobei die erste Halbleiter-Solarzelle eine erste Gitterkonstante aufweist, und der Solarzellenstapel einen zweiten Solarzellenteil mit einer Oberseite und einer Unterseite und einer zweiten Halbleiter-Solarzelle und wobei die zweite Halbleiter-Solarzelle eine zweite Gitterkonstante aufweist und wobei der erste Solarzellenteil mit der Unterseite auf der Oberseite des zweiten Solarzellenteils kraftschlüssig aufeinander angeordnet ist und wobei zwischen der Unterseite des ersten Solarzellenteils und der Oberseite des zweiten Solarzellenteils ein abrupter Unterschied zwischen der ersten Gitterkonstante und der zweiten Gitterkonstante ausgebildet ist und der Unterschied zwischen der ersten Gitterkonstante und der zweiten Gitterkonstanten mindestens 0.5% beträgt oder eine amorphe Schicht ausgebildet ist; und wobei der erste Solarzellenteil und / oder der zweite Solarzellenteil zusätzlich zu der ersten Halbleiter-Solarzelle oder der zweiten Halbleiter-Solarzelle eine weitere Halbleiter-Solarzelle umfasst und wobei der erste Solarzellenteil und / oder der zweite Solarzellenteil eine metamorphe Zwischenschicht umfasst, und wobei die metamorphe Zwischenschicht eine erste Schichtdicke umfasst und die metamorphe Zwischenschicht entlang der Dickenerstreckung der Schicht die Gitterkonstante um mindestens 0.5% verändert.

Es sei angemerkt, dass zwischen den einzelnen Solarzellen eine elektrische Wirkverbindung ausgebildet ist, d.h. der Solarzellenstapel ist an der Oberseite und an der Unterseite elektrisch angeschlossen. Bei Lichteinfall auf die Oberseite des Solarzellenstapels baut sich infolge der Konversion von Licht eine elektrische Spannung auf. Die Spannung lässt sich mittels der elektrischen Kontakte abgreifen.

Ein Vorteil ist, dass sich trotz der Ausbildung einer metamorphen Schicht in dem ersten Solarzellenteil und / oder dem zweiten Solarzellenteil ein Solarzellenstapel kostengünstig und zuverlässig zusammenfügen, d.h. bonden lässt. Gerade in der Kombination von metamorphen Schichten und dem Zusammenfügen lässt sich nach Untersuchungen auf höchst vorteilhafte Weise bei den III-V Verbindungen und in Zusammenhang mit einer Germanium Schicht und oder einer Schicht aus einer Germaniumverbindung die jeweilige Gitterkonstante derart wählen, dass sich sehr unterschiedliche Bandlücken ausbilden und sich ein hoher Gesamtwirkungsgrad des Solarzellenstapels ergibt, ohne dass an der Grenzfläche, d.h. zwischen dem ersten Solarzellenteil und dem zweiten Solarzellenteil, nochmals eine aufwändige metamorphe Zwischenschicht oder mehrerer Zwischenschichten ausgebildet werden müssen. Insbesondere wird vermieden, dass sich die Gitterkonstante in einer ersten metamorphen Zwischenschicht erst vergrößert und in einer zweiten nachfolgenden metamorphen Zwischenschicht verkleinert, oder vice versa. Untersuchungen haben gezeigt, dass eine Veränderung der Gitterkonstanten in unterschiedlichen Richtungen die Kristallqualität stark verringert.

Es zeigte sich in völlig überraschender Weise, dass trotz der erheblichen Oberflächenrauhigkeit aufgrund der bereits eingefügten metamorphen Zwischenschicht und trotz des Gitterunterschiedes, welcher notwendig ist, um den Wirkungsgrad durch verschiedene aufeinander abgestimmte Bandlücken weiter zu erhöhen, ein Solarzellenstapel einfach und zuverlässig ausbilden lässt.

Weiterhin ist vorteilhaft, dass sich zwei Solarzellenteile getrennt und unabhängig voneinander auf unterschiedlichen Substraten mit hoher Kristallqualität herstellen und anschließend zu einem Stapel mit wenigstens einer Tripelzelle zusammenfügen lassen, ohne dass die beiden Solarzellenteile zueinander gitterangepasst epitaxiert werden müssen. Ferner erübrigt sich gegenüber nicht gebondeten Solarzellenstapel ein sehr aufwändiger und nur mit geringer Ausbeute behafteter Epitaxieprozess mittels einer oder mehrerer metamorphen Zwischenschichten, in welchen sich die Gitterkonstante in unterschiedliche Richtungen verändert, und welche vielfache jeweils aufeinander abgestimmte Epitaxieschritte benötigen.

Sowohl vor als auch nach dem Zusammenfügen lassen sich die Substrate entfernen und vorzugsweise für eine Herstellung von weiteren Solarzellenteilen wiederverwenden. Hierdurch lassen sich insbesondere in dem Bereich der III-V Solarzellen auf vorteilhafte Weise besonders zuverlässige und kostengünstige gestapelte Mehrfachsolarzelle mit hoher Ausbeute herstellen. Des Weiteren wird es möglich auch wesentlich kostengünstige Substrate wie beispielsweise Ge, eine Verbindung aus Ge oder GaAs zu verwenden. Untersuchungen haben gezeigt, dass insbesondere das sehr teuere InP Substrat sich nunmehr durch ein Germaniumsubstrat ersetzten lässt und sich die Variation der Bandlücken dennoch optimal auf das solare Wellenlängespektrum anpassen lässt. Im Unterschied zu der Verwendung einer Kombination von Si Trägerschichten mit III-V Halbleiterverbindungen wird bei Verwendung von GaAs und / oder Ge Trägerschichten eine thermische Fehlanpassung zwischen den Solarzellenteilen vermieden. Ge weist einen vergleichbaren thermischen Ausdehnungskoeffizienten wie die III-V Halbleiterverbindungen auf.

In einer bevorzugten Ausführungsform ist zwischen der ersten Halbleiter-Solarzelle oder der zweiten Halbleiter-Solarzelle und der weiteren Halbleiter-Solarzelle eines Solarzellenteils eine metamorphe Zwischenschicht ausgebildet. Hierdurch lassen sich zwei unmittelbar aufeinanderfolgende Solarzellen mit unterschiedlichen Gitterkonstanten ausbilden.

In einer anderen Ausführungsform ist die erste Halbleiter-Solarzelle und / oder die zweite Halbleiter-Solarzelle unmittelbar an der Grenzfläche, welche durch das Zusammenfügen des ersten Solarzellenteils mit dem zweiten Solarzellenteil gebildet wird, angeordnet. Demgemäß sind zwischen der ersten Halbleiter-Solarzelle und zwischen der zweiten Halbleiter-Solarzelle die amorphe Schicht und die abrupte Änderung der Gitterkonstanten ausgebildet. Des Weiteren sei angemerkt, dass der erste Solarzellenteil mit dem zweiten Solarzellenteil an der Grenzfläche elektrisch vorzugsweise mittels einer Tunneldiode verbunden ist.

In einer Weiterbildung weisen die Solarzellen in einem der beiden Solarzellenteile ausschließlich gitterangepasste Schichten auf. In einer alternativen Ausführungsform weisen beide Solarzellenteile wenigstens eine metamorphe Schicht auf. Es ist bevorzugt, dass der erste Solarzellenteil und / oder der zweite Solarzellenteil als Mehrfach-Solarzelle ausgebildet sind. Vorteilhaft ist, wenn der erste Solarzellenteil und der zweite Solarzellenteil stoffschlüssig insbesondere bei Ausbildung einer kristallinen oder amorphen Halbleiter-Grenzschicht miteinander vorzugsweise durch Waferbonding, höchstvorzugsweise durch Halbleiterbonding miteinander verbunden. In einer anderen Weiterbildung sind die beiden Solarzellenteile mit einem leitfähigen Kleber verbunden.

In einer alternativen Ausführungsform lässt sich der erste Solarzellenteil mit dem zweiten Solarzellenteil mittels einer Befestigungsvorrichtung, insbesondere einer Klemmvorrichtung, mechanisch verbinden.

Untersuchungen haben gezeigt, dass es vorteilhaft ist, wenn der erste Solarzellenteil oder der zweite Solarzellenteil eine Tripel- oder- Quadrupel Solarzelle enthalten. In einer Ausführungsform weisen hierbei der erste Solarzellenteil und / oder der zweite Solarzellenteil mehrere metamorphe Zwichenschichten auf. Gemäß einer alternativen Ausführungsform weisen der erste Solarzellenteil und / oder der zweite Solarzellenteil eine Tragschicht auf. Gemäß einer alternativen Ausführung weisen der erste Solarzellenteil und / oder der zweite Solarzellenteil keine Tragschicht auf.

In einer Weiterbildung ist es bevorzugt, dass der zweite Solarzellenteil eine Halbleiter-Solarzelle aus Germanium und eine Halbleiter-Solarzelle aus einer GaInAs oder Al-InGaAs Verbindung umfasst und der erste Solarzellenteil eine Halbleiter-Solarzelle aus einer GaAs, AlGaAs, InGaAs oder AlInGaAs Verbindung und eine Halbleiter-Solarzelle aus einer InGaP oder AlInGaP Verbindung umfasst. In einer anderen Weiterbildung umfasst der zweite Solarzellenteil eine Halbleiter-Solarzelle aus Germanium und eine Halbleiter-Solarzelle aus einer GaInAs oder AlGaInAs Verbindung und der erste Solarzellenteil eine Halbleiter-Solarzelle aus einer GaAs oder InGaAs Verbindung und eine Halbleitersolarzelle aus AlGaAs oder AlInGaAs Verbindung und eine Halbleiter-Solarzelle aus einer AlInGaP Verbindung.

Bevorzugt ist, dass der erste Solarzellenteil und der zweite Solarzellenteil vier Halbleiter-Solarzellen mit einer ersten Bandlücke im Bereich von 1.8 eV bis 2.0 eV und mit einer zweiten Bandlücke im Bereich von 1.3 bis 1.5 eV und mit einer dritten Bandlücke im Bereich von 0.9 bis 1.1 eV und mit einer vierten Bandlücke im Bereich von 0.6 bis 0.7 eV umfassen.

In einer alternativen Ausführung umfasst der erste Solarzellenteil und der zweite Solarzellenteil insgesamt fünf Halbleiter-Solarzellen mit einer ersten Bandlücke in einem Bereich von 1.9 bis 2.1 eV und mit einer zweiten Bandlücke von in einem Bereich von 1.6 bis 1.8 eV und mit einer dritten Bandlücke in einem Bereich von 1.4 bis 1.6 eV und mit einer vierten Bandlücke in einem Bereich von 0.9 bis 1.1 eV und mit einer fünften Bandlücke in einem Bereich von 0.6 bis 0.7 eV.

In einer alternativen Ausführung umfasst der erste Solarzellenteil und der zweite Solarzellenteil insgesamt sechs Halbleiter-Solarzellen mit einer ersten Bandlücke in einem Bereich von 1.9 bis 2.1 eV und mit einer zweiten Bandlücke von in einem Bereich von 1.6 bis 1.9 eV und mit einer dritten Bandlücke in einem Bereich von 1.4 bis 1.6 eV und mit einer vierten Bandlücke in einem Bereich von 1.0 bis 1.5 eV und mit einer fünften Bandlücke in einem Bereich von 0.8 bis 1.1 eV und mit einer sechsten Bandlücke in einem Bereich von 0.6 bis 0.7 eV.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: einen schematischen Querschnitt auf eine erste Ausführungsform eines Solarzellenmoduls,
- Figur 2: einen schematischen Querschnitt auf eine zweite Ausführungsform eines Solarzellenmoduls,
- Figur 3: einen schematischen Querschnitt auf eine dritte Ausführungsform eines Solarzellenmoduls,
- Figur 4: einen schematischen Querschnitt auf eine vierte Ausführungsform eines Solarzellenmoduls,
- Figur 5a-e: einen schematischen Querschnitt auf eine siebente Ausführungsform eines Solarzellenmoduls,

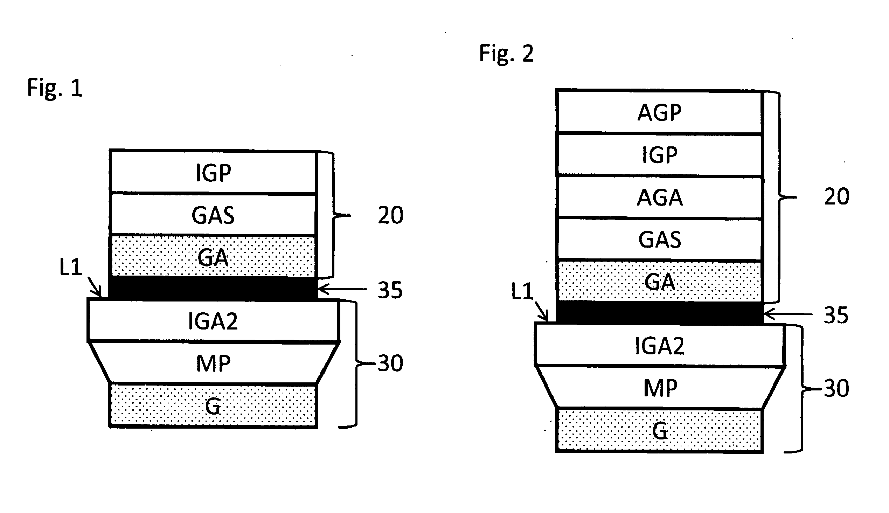

Die Abbildung der Figur 1 zeigt einen schematischen Querschnitt eine erste erfindungsgemäße Ausführungsform eines Solarzellenmoduls 10 mit einer einem ersten Solarzellenteil 20 und einem zweiten Solarzellenteil 30. Der erste Solarzellenteil 20 weist eine Oberseite und eine Unterseite auf. In dem ersten Solarzellenteil 20 ist als erste Schicht eine GaAs Schicht GA vorzugsweise als Trägerschicht ausgebildet. Auf der Schicht GA ist eine erste Halbleiter-Solarzelle in Form einer GaAs Solarzelle GAS, vorzugsweise mit einer Bandlücke in einem Bereich zwischen 1.3 bis 1.5 eV angeordnet. Die erste Halbleiter-Solarzelle weist eine erste Gitterkonstante auf. Auf der ersten Grenzflächenhalbleiter-Solarzelle ist eine weitere Halbleiter-Solarzelle in Form einer InGaP Solarzelle IGP, vorzugsweise mit einer Bandlücke in einem Bereich zwischen 1.8 bis 2.0 eV angeordnet.

Der zweite Solarzellenteil 30 weist eine Oberseite und eine Unterseite auf. In dem zweiten Solarzellenteil 30 ist eine weitere Halbleiter-Solarzelle in Form einer Ge-Solarzelle G, vorzugsweise mit einer Bandlücke in einem Bereich zwischen 0.6 bis 0.7 eV ausgebildet. Alternativ lässt sich anstelle oder zusätzlich zu der weiteren Solarzelle eine erste Schicht aus Ge oder einer Ge-Verbindung ausbilden. Die erste Schicht ist vorzugsweise als Trägerschicht ausgebildet. Auf der Ge-Solarzelle G ist eine metamorphe Zwischenschicht MP mit einer ersten Schichtdicke ausgebildet. Die metamorphe Zwischenschicht MP verändert entlang der Dickenerstreckung die Gitterkonstante um mindestens 0.5%, wobei die an die weitere Halbleiter-Solarzelle angrenzende Schicht der metamorphen Zwischenschicht MP die kleinere Gitterkonstante aufweist. Auf der metamorphen Zwischenschicht MP ist eine zweite Halbleiter-Solarzelle in Form einer InGaAs-Solarzelle IGA2, vorzugsweise mit einer Bandlücke in einem Bereich zwischen 0.9 eV bis 1.1 eV, angeordnet. Die zweite Halbleiter-Solarzelle weist eine zweite Gitterkonstante auf.

Die Unterseite des ersten Solarzellenteils 20 ist mit der Oberseite des zweiten Solarzellenteils 30 an einer Grenzfläche 35 kraftschlüssig und insbesondere stoffschlüssig aufeinander angeordnet, so dass sich ein senkrechter Stapel von vier Solarzellen mit vier unterschiedlichen Bandlücken ausgebildet. An der Grenzfläche 35 zwischen der Unterseite des ersten Solarzellenteils 20 und der Oberseite des zweiten Solarzellenteils 30 ist ein abrupter Unterschied zwischen der ersten Gitterkonstante und der zweiten Gitterkonstante ausgebildet. Hierbei ist die erste Gitterkonstante kleiner als die zweite Gitterkonstante, wobei der Unterschied zwischen der ersten Gitterkonstante und der zweiten Gitterkonstanten mindestens 0.5% beträgt. Veranschaulicht ist der Unterschied zwischen der ersten Gitterkonstante und der zweiten Gitterkonstante durch einen lateralen Breitenunterschied L1 zwischen dem ersten Solarzellenteil 20 und dem zweiten Solarzellenteil 30.

Gemäß einer nicht dargestellten Alternative ist an der Grenzfläche an der Unterseite des ersten Solarzellenteils 20 und / oder an der Oberseite des zweiten Solarzellenteils 30 eine dünne amorphe Schicht ausgebildet. Vorzugsweise liegt die Schichtdicke der amorphen Schicht in Bereich unter 20 nm, höchst vorzugsweise unterhalb 8 nm.

Die Abbildung der Figur 2 zeigt einen schematischen Querschnitt einer zweiten erfindungsgemäßen Ausführungsform eines Solarzellenmoduls 10. Nachfolgend werden nur die Unterschiede zu der Ausführungsform der Figur 1 erläutert. Der erste Solarzellenteil 20 umfasst zusätzlich als weitere Halbleiter-Solarzelle eine AlGaAs-Solarzelle AGA, vorzugsweise mit einer Bandlücke in einem Bereich zwischen 1.4 bis 1.6 eV. Aufliegend auf die weitere Halbleiter-Solarzelle ist eine weitere Halbleiter-Solarzelle in Form einer InGaP Solarzelle IGP, vorzugsweise mit einer Bandlücke in einem Bereich zwischen 1.6 bis 1.9 eV angeordnet. Hierauf aufliegend ist eine zusätzliche weitere Halbleiter-Solarzelle in Form einer AlInGaP-Solarzelle AGP, vorzugsweise mit einer Bandlücke in einem Bereich zwischen 1.9 bis 2.1, eV, angeordnet. Insgesamt umfasst der erste Solarzellenteil vier Solarzellen und der gesamte Solarzellenstapel 6 Solarzellen. Der zweite Solarzellenteil 20 entspricht in dem Aufbau dem der Figur 1.

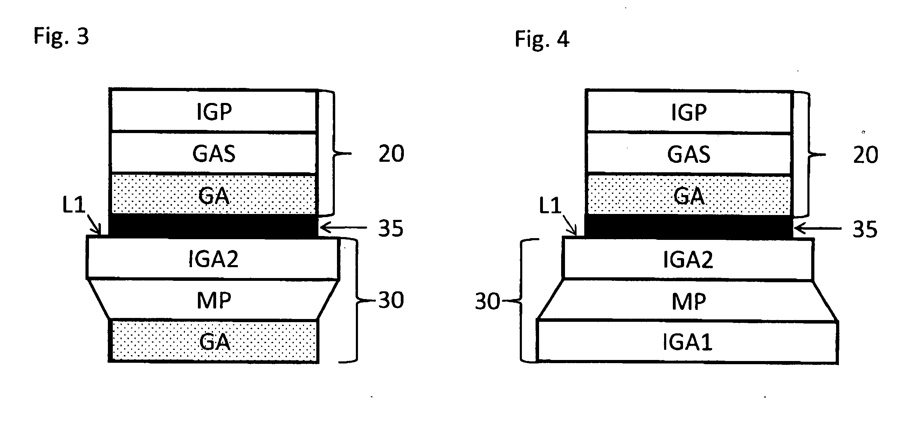

Die Abbildung der Figur 3 zeigt einen schematischen Querschnitt einer dritten erfindungsgemäßen Ausführungsform eines Solarzellenmoduls 10. Nachfolgend werden nur die Unterschiede zu der Ausführungsformen der vorangegangenen Figuren erläutert. Der erste Solarzellenteil 20 entspricht in dem Aufbau dem der Figur 1.

Demhingegen ist in dem zweiten Solarzellenteil 30 die zweite Halbleiter-Solarzelle in Form einer InGaAs-Solarzelle IGA2, vorzugsweise mit einer Bandlücke in einem Bereich zwischen 0.9eV bis 1.2.eV, ausgebildet. Die unterhalb der metamorphen Zwischenschicht MP angeordnete zweite Schicht ist in Form der GaAs Schicht GA, vorzugsweise als Trägerschicht ausgebildet.

Die Abbildung der Figur 4 zeigt einen schematischen Querschnitt einer vierten erfindungsgemäßen Ausführungsform eines Solarzellenmoduls 10. Nachfolgend werden nur die Unterschiede zu der Ausführungsformen der vorangegangenen Figuren erläutert. Der erste Solarzellenteil 20 entspricht in dem Aufbau dem ersten Solarzellenteil 20 der Figur 1.

Demhingegen ist in dem zweiten Solarzellenteil 30 die weitere Halbleiter-Solarzelle in Form einer InGaAs-Solarzelle IGA1, vorzugsweise mit einer Bandlücke in einem Bereich zwischen 0.5 bis 0.7 eV ausgebildet. Auf der InGaAs-Solarzelle IGA1 ist die metamorphe Zwischenschicht MP mit der ersten Schichtdicke ausgebildet. Die metamorphe Zwischenschicht MP verändert entlang der Dickenerstreckung die Gitterkonstante wiederum um mindestens 0.5%, wobei die an die zweite Halbleiter-Solarzelle angrenzende Schicht der metamorphen Zwischenschicht MP die kleinste Gitterkonstante innerhalb der metamorphen Zwischenschicht MP aufweist. Auf der metamorphen Zwischenschicht MP ist die zweite Halbleiter-Solarzelle in Form einer InGaAs-Solarzelle IGA2, vorzugsweise mit einer Bandlücke in einem Bereich zwischen 0.9eV bis 1.2 eV, angeordnet.

In einer nicht gezeigten alternativen Ausführungsform ist oberhalb der zweiten Halbleiter-Solarzelle eine weitere metamorphe Zwischenschicht mit der zweiten Schichtdicke ausgebildet, wobei die an die zweite Halbleiter-Solarzelle angrenzende Schicht der weiteren metamorphen Zwischenschicht die größte Gitterkonstante innerhalb der weiteren metamorphen Zwischenschicht aufweist. Zusätzlich ist in einer weiteren nicht gezeigten alternativen Ausführungsform die oberhalb der weiteren metamorphen Zwischenschicht angeordnete zweite Schicht in Form der GaAs Schicht, vorzugsweise als Trägerschicht ausgebildet und steht in einem stoffschlüssigen Kontakt mit der Unterseite des ersten Solarzellenteils 20. Insgesamt umfasst der Solarzellenstapel 10 in der vierten Ausführungsform vier Solarzellen. Wird die GaAs Trägerschicht vor dem Zusammenfügen entfernt, lässt sich auch die weitere metamorphe Zwischenschicht mit entfernen und es ergibt sich die in Abbildung Figur 4 gezeigte erfindungsgemäße Ausführung.

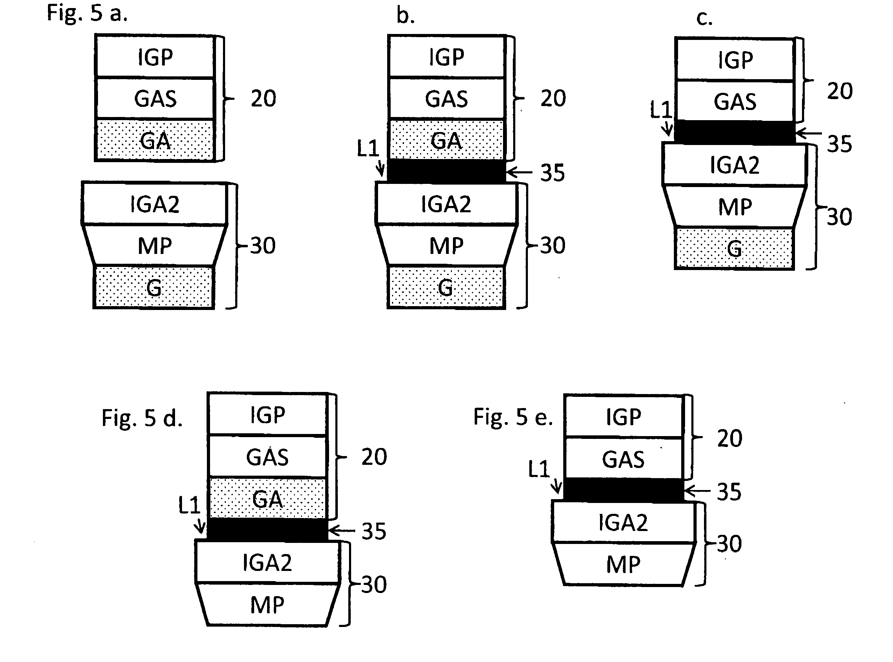

Die Abbildung der Figur 5a - e zeigt einen schematischen Querschnitt einer fünften erfindungsgemäßen Ausführungsform eines Solarzellenstapels 10 in einem nicht geborideten Zustand gemäß der Figur 5a und den daraus resultierenden möglichen gebondeten Abwandlungen gemäß der Figur 5b- e. Nachfolgend werden nur die Unterschiede zu der Ausführungsformen der vorangegangenen Figuren erläutert. Inder Figur 5a entspricht der erste Solarzellenteil 20 dem Aufbau des ersten Solarzellenteils 20 der Figur 1 und der zweite Solarzellenteil 30 dem Aufbau des zweiten Solarzellenteils 30 der Figur 1, d. h. nach dem Bonden entsteht jeweils ein Solarzellenstapel mit drei oder vier Solarzellen, je nachdem inwieweit die aus Ge oder einer Ge-Verbindung bestehende Schicht als Trägerschicht und oder als Solarzelle ausgebildet ist.

In der ersten Abwandlung gemäß der Figur 5b sind der erste Solarzellenteil 20 und der zweite Solarzellenteil 30 mittels eines Bondprozesses zusammengefügt dargestellt, wobei der jeweilige Schichtaufbau des ersten Solarzellenteils 20 und des zweiten Solarzellenteils 30 unverändert sind und hierdurch die erste Abwandlung unmittelbar der Ausführungsform der Figur 1 entspricht, jedoch aus Gründen der Übersichtlichkeit nochmals angeführt ist.

In der zweiten Abwandlung gemäß der Figur 5c sind der erste Solarzellenteil 20 und der zweite Solarzellenteil 30 mittels eines Bondprozesses wiederum zusammengefügt dargestellt, wobei nur der Schichtaufbau des ersten Solarzellenteils 20 verändert ist. Die erste als GaAs Schicht GA ausgebildet Trägerschicht ist vor dem Zusammenfügen des ersten Solarzellenteils 20 mit dem zweiten Solarzellenteils 30 entfernt worden.

In der dritten Abwandlung gemäß der Figur 5d sind der erste Solarzellenteil 20 und der zweite Solarzellenteil 30 mittels eines Bondprozesses wiederum zusammengefügt dargestellt, wobei nur der Schichtaufbau des zweiten Solarzellenteils 30 verändert ist. Hierbei ist die vorzugsweise als Trägerschicht ausgebildete erste Schicht aus Ge oder einer Ge-Verbindung vor oder nach dem Bonden entfernt worden. Vorliegend ist hierdurch eine Dreifachsolarzelle entstanden. Wird die Ge Schicht G nur teilweise entfernt, so dass ihr P-N Übergang erhalten bleibt, entsteht eine dünnere Vierfachsolarzelle.

In der vierten Abwandlung gemäß der Figur 5e sind der erste Solarzellenteil 20 und der zweite Solarzellenteil 30 mittels eines Bondprozesses wiederum zusammengefügt dargestellt, wobei der Schichtaufbau des ersten Solarzellenteils 20 und der Schichtaufbau des zweiten Solarzellenteils 30 verändert ist. In soweit handelt es sich um eine Kombination der zweiten Abwandlung und der dritten Abwandlung. Sowohl bei dem ersten Solarzellenteil 20 ist die als Tragschicht ausgebildete weitere Schicht in Form der GaAs Trägerschicht vor dem Bonden, als auch bei dem zweiten Solarzellenteil 30 vorzugsweise als Trägerschicht ausgebildete erste Schicht aus Ge oder einer Ge-Verbindung vor oder nach dem Bonden entfernt worden. Vorliegend ist hierdurch ebenfalls eine Dreifachsolarzelle entstanden. Wird die Ge Schicht G nur teilweise entfernt, so dass ihr P-N Übergang erhalten bleibt, entsteht eine dünne Vierfachsolarzelle.

## Patentansprüche

1. Solarzellenstapel (10) aufweisend wenigstens drei Halbleiter-Solarzellen aus Ge und / oder einer Ge-Verbindung und / oder einer III-V Verbindung, wobei jede Halbleiter-Solarzelle einen P/N Übergang beinhaltet, mit
- einem ersten Solarzellenteil (20), mit einer Oberseite und einer Unterseite und einer ersten Halbleiter-Solarzelle und wobei die erste Halbleiter-Solarzelle eine erste Gitterkonstante aufweist, und
- einem zweiten Solarzellenteil (30) mit einer Oberseite und einer Unterseite und einer zweiten Halbleiter-Solarzelle und wobei die zweite Halbleiter-Solarzelle eine zweite Gitterkonstante aufweist,
wobei der erste Solarzellenteil (20) mit der Unterseite auf der Oberseite des zweiten Solarzellenteils (30) kraftschlüssig aufeinander angeordnet ist,
**dadurch gekennzeichnet, dass**
zwischen der Unterseite des ersten Solarzellenteils (20) und der Oberseite des zweiten Solarzellenteils (30) ein abrupter Unterschied zwischen der ersten Gitterkonstante und der zweiten Gitterkonstante ausgebildet ist und der Unterschied zwischen der ersten Gitterkonstante und der zweiten Gitterkonstanten mindestens 0.5% beträgt oder eine amorphe Schicht ausgebildet ist, und wobei
der erste Solarzellenteil und / oder der zweite Solarzellenteil (30) zusätzlich zu der ersten Halbleiter-Solarzelle oder der zweiten Halbleiter-Solarzelle eine weitere Halbleiter-Solarzelle umfasst und
der erste Solarzellenteil (20) und / oder der zweite Solarzellenteil (30) eine metamorphe Zwischenschicht (MP) umfasst, und
und die metamorphe Zwischenschicht (MP) eine erste oder zweite Schichtdicke umfasst und die metamorphe Zwischenschicht (MP) entlang der Dickenerstreckung der metamorphen Zwischenschicht (MP) die Gitterkonstante um mindestens 0.5% verändert.

2. Solarzellenstapel (10) nach Anspruch 1, **dadurch gekennzeichnet, dass** zwischen der ersten Halbleiter-Solarzelle oder der zweiten Halbleiter-Solarzelle und der weiteren Halbleiter-Solarzelle eine metamorphe Zwischenschicht (MP) ausgebildet ist.

3. Solarzellenstapel (10) nach Anspruch 1 oder Anspruch 2, **dadurch gekennzeichnet, dass** ein Solarzellenteil (20, 30) ausschließlich gitterangepassten Schichten umfasst.

4. Solarzellenstapel (10) nach einem der Ansprüche 1 bis 3, **dadurch gekennzeichnet, dass** der erste Solarzellenteil (20) und der zweite Solarzellenteil (30) stoffschlüssig miteinander verbunden sind.

5. Solarzellenstapel (10) nach einem der Ansprüche 1 bis 3, **dadurch gekennzeichnet, dass** der erste Solarzellenteil (20) mit dem zweiten Solarzellenteil (30) durch Halbleiterbonding miteinander verbunden sind.

6. Solarzellenstapel (10) nach einem der Ansprüche 1 bis 3, **dadurch gekennzeichnet, dass** der erste Solarzellenteil (20) mit dem zweiten Solarzellenteil (30) durch Waferbonding miteinander verbunden sind.

7. Solarzellenstapel (10) nach einem der Ansprüche 1 bis 3, **dadurch gekennzeichnet, dass** der erste Solarzellenteil mit dem zweiten Solarzellenteil mittels einer Befestigungsvorrichtung, insbesondere einer Klemmvorrichtung, mechanisch verbunden sind.

8. Solarzellenstapel (10) nach einem der vorstehenden Ansprüche, **dadurch gekennzeichnet, dass** der erste Solarzellenteil (20) oder der zweite Solarzellenteil (30) eine Tripel- oder- Quadrupel Solarzelle enthält.

9. Solarzellenstapel (10) nach einem der vorstehenden Ansprüche, **dadurch gekennzeichnet, dass** der erste Solarzellenteil (20) und / oder der zweite Solarzellenteil (30) mehrere metamorphe Zwischenschcihten aufweisen.

10. Solarzellenstapel (10) nach einem der vorstehenden Ansprüche, **dadurch gekennzeichnet, dass** das der erste Solarzellenteil (20) und / oder der zweite Solarzellenteil (30) eine Tragschicht umfasst.

11. Solarzellenstapel (10) nach einem der Ansprüche 1 bis 9, **dadurch gekennzeichnet, dass** der erste Solarzellenteil (20) und / oder der zweite Solarzellenteil (30) keine Tragschicht aufweisen.

12. Solarzellenstapel (10) nach einem der vorstehenden Ansprüche, **dadurch gekennzeichnet, dass** der zweite Solarzellenteil (30) eine Halbleiter-Solarzelle aus Germanium und eine Halbleiter-Solarzelle aus einer InGaAs oder AlInGaAs Verbindung umfasst und der erste Solarzellenteil (20) eine Halbleiter-Solarzelle aus einer GaAs, AlGaAs, InGaAs oder AlInGaAs Verbindung und eine Halbleiter-Solarzelle aus einer InGaP oder InAlGaP Verbindung umfasst.

13. Solarzellenstapel (10) nach einem Ansprüche 1 bis 11, **dadurch gekennzeichnet, dass** der zweite Solarzellenteil (30) eine Halbleiter-Solarzelle aus Germanium und eine Halbleiter-Solarzelle aus einer InGaAs oder AlInGaAs Verbindung umfasst und der erste Solarzellenteil (20) eine Halbleiter-Solarzelle aus einer GaAs oder InGaAs Verbindung und eine Halbleitersolarzelle aus AlGaAs oder AlInGaAs Verbindung und eine Halbleiter-Solarzelle aus einer AlInGaP Verbindung umfasst.

14. Solarzellenstapel (10) nach einem der vorstehenden Ansprüche, **dadurch gekennzeichnet, dass** der erste Solarzellenteil (20) und der zweite Solarzellenteil (30) vier Halbleiter-Solarzellen mit einer ersten Bandlücke im Bereich von 1.8 eV bis 2.0 eV und mit einer zweiten Bandlücke im Bereich von 1.3 bis 1.5 eV und mit einer dritten Bandlücke im Bereich von 0.9 bis 1.1 eV und mit einer vierten Bandlücke im Bereich von 0.6 bis 0.7 eV umfassen.

15. Solarzellenstapel (10) nach einem der vorstehenden Ansprüche, **dadurch gekennzeichnet, dass** der erste Solarzellenteil (20) und der zweite Solarzellenteil (30) fünf Halbleiter-Solarzellen mit einer ersten Bandlücke im Bereich von 1.9 bis 2.1 eV und mit einer zweiten Bandlücke von 1.6 bis 1.8 eV und mit einer dritten Bandlücke im Bereich von 1.4 bis 1.6 eV und mit einer vierten Bandlücke im Bereich von 0.9 bis 1.1 eV und mit einer fünften Bandlücke im Bereich von 0.6 bis 0.7 eV umfassen.

16. Solarzellenstapel (10) nach einem der vorstehenden Ansprüche, **dadurch gekennzeichnet, dass** der erste Solarzellenteil (20) und der zweite Solarzellenteil (30) fünf Halbleiter-Solarzellen mit einer ersten Bandlücke im Bereich von 1.9 bis 2.1 eV und mit einer zweiten Bandlücke von 1.6 bis 1.9 eV und mit einer dritten Bandlücke im Bereich von 1.4 bis 1.6 eV und mit einer vierten Bandlücke im Bereich von 1.0 bis 1.5 eV und mit einer fünften Bandlücke im Bereich von 0.8 Bis 1.1 eV und mit einer sechsten Bandlücke im Bereich von 0.6 bis 0.7 eV umfassen.
